Europäisches Patentamt

European Patent Office

Office européen des brevets

(11) Veröffentlichungsnummer: **0 184 063**
**B1**

(12) **EUROPÄISCHE PATENTSCHRIFT**

(45) Veröffentlichungstag der Patentschrifft:
**17.01.90**

(21) Anmeldenummer: **85114625.8**

(22) Anmeldetag: **18.11.85**

(51) Int. Cl. ⁴: **G 03 F 9/00, B 41 C 1/00,**
**G 05 D 3/12**

(54) Verfahren zum Positionieren von Druckformen vor dem Stanzen von Registerlochungen sowie Anordnung zum Durchführen des Verfahrens.

(30) Priorität: **27.11.84 DE 3443178**

(43) Veröffentlichungstag der Anmeldung:
**11.06.86 Patentblatt 86/24**

(45) Bekanntmachung des Hinweises auf die Patenterteilung:
**17.01.90 Patentblatt 90/03**

㊸④ Bennante Vertragsstaaten:
**BE DE FR GB IT NL**

(56) Entgegenhaltungen:
**DE-A-2 934 603**
**DE-A-3 116 634**
**DE-A-3 206 119**
**DE-A-3 328 247**

(73) Patentinhaber: **HOECHST AKTIENGESELLSCHAFT**
**Postfach 80 03 20**
**D-6230 Frankfurt am Main 80 (DE)**

(72) Erfinder: **Schön, Klaus-Peter**
**Rathenauplatz 14**
**D-6200 Wiesbaden (DE)**
Erfinder: **Reuter, Klaus**
**Stiegelstrasse 11**
**D-6200 Wiesbaden (DE)**

LIBERGRAF, STOCKHOLM 1990

## Beschreibung

Die Erfindung betrifft ein Verfahren zum Positionieren von Druckformen anhand von Ausrichtmarken, in dem während der Belichtung der Druckform durch eine Vorlage gleichzeitig Meßmarken in vorgegebener Lage zum Satzspiegel der Vorlage aufbelichtet werden, die anschließend mit der Druckform durch Toner entwickelt werden, sowie eine Anordnung zum Durchführen des Verfahrens.

Aus dem Dokument DE-A-3 328 247 ist ein Verfahren zum Bilden von Ausrichtmarken bekannt, in dem während der Belichtung der Druckform durch eine Vorlage gleichzeitig Meßmarken in vorgegebener Lage zum Satzspiegel der Vorlage aufbelichtet werden, die anschließend mit der Druckform durch Toner entwickelt werden. Dabei kann die Ausrichtmarke gleichzeitig mit oder vor oder nach dem Drucken des Bildes auf eine Platte auf diese fokussiert werden.

Aus dem Dokument DE-A-2 934 603 ist ein Verfahren zum Positionieren von Druckformen in x- und y-Richtung anhand von Ausrichtmarkierungen bekannt, in dem die Meßmarken optisch vermessen werden und die Druckformen so lange durch von den Meßmarken empfangene Meßwerte ausgerichtet werden, bis die abgeschattete Fläche eines ersten Elementteils die gleiche ist wie die Fläche eines zweiten Elementteils eines fotoelektrischen Detektorelements, das in die beiden Elementteile unterteilt ist. Jeder dieser Elementteile sendet sein eigenes fotoelektrisches Signal aus, wobei die Abdeckung der Elementteile durch die jeweilige abgetastete Ausrichtmarkierung erfolgt. Ein Maximalwert der auftretenden Meßwerte wird hierbei zum Positionieren eines Gegenstandes nicht verwendet, vielmehr werden die Relativwerte der abgeschatteten Flächen der Elementteile aus der Verminderung der durch die Elementteile abgegebenen Signale im Vergleich zu ihren Maximalwerten bei nicht abgeschatteten Elementteilen berechnet. Bei diesem Verfahren kann es zu einem Überschießen der Bewegung der zu positionierenden Druckformeneinrichtung kommen, woraufhin die Bewegungsrichtung der Druckform umgekehrt wird und es zu einem Anhalten der Bewegung in der endgültigen Position kommt, sobald die beiden abgeschatteten Flächen des ersten und zweiten Elementteils des Detektorelements gleichgroß sind.

Druckformen, wie z. B. Druckplatten, werden nach der Belichtung und Entwicklung in einem Druckplattenentwicklungsgerät automatischen Plattenstanzen zugeführt, in denen Registerlochungen in die einzelne Druckplatte gestanzt werden, die es ermöglichen, die Druckplatte jeweils exakt ausgerichtet auf einen Druckzylinder für den Druckvorgang aufzuspannen.

Bei bekannten halbautomatischen Plattenstanzen, wie sie die Firma Barenschee, Lüneburg, Bundesrepublik Deutschland, herstellt, werden die Platten manuell eingelegt und entnommen, während der Stanzvorgang automatisch erfolgt, ausgelöst über eine Dreipunktkontaktanlage, sobald die Druckplatte an drei Konstaktstellen der Anlage anliegt. Die Registerlochungen von Druckplatten werden u. a. auch für die registerhaltige Plattenabkantung, die für das Aufspannen der Druckplatten auf die Rotationsmaschine verlangt wird, vorgenommen. Für die registerhaltige Plattenabkantung wird im allgemeinen ein automatischer Abkantautomat eingesetzt, der sich aus einer Sammeleinheit, einer Eintakteinheit und einer Abkanteinheit zusammensetzt. Die Sammeleinheit des Automaten schließt an das Druckplattenentwicklungsgerät an, von dem die Platten je nach Bedarf in gerader Weiterführung oder mit einer Richtungsumsetzung übernommen werden. In der Abkanteinheit wird die Druckplatte mittels Registerstifte genauestens positioniert und anschließend exakt abgekantet.

Das Stanzen von Registerlochungen wird im allgemeinen nach der Entwicklung der Druckplatte vorgenommen, da ein Stanzen vor dem Entwickeln der Druckplatte deren Betonerung erschwert und u.U. zum Zusammenbruch der Aufladespannung infolge von Kriechströmen führen kann, die sich über die Stanzung von der zu entwickelnden Schicht der Druckplatte in Richtung Rückseite der Druckplatte ausbilden. Ein Zusammenbruch dieser Aufladespannung führt im allgemeinen auch zu einem unerwünschten Austrag an Trägerteilchen des Entwicklers.

Erfolgt das Stanzen nach dem Entwickeln der Druckplatte ist es notwendig, die Lage der Druckplatte während des Belichtens und des Stanzens exakt zu positionieren. Bei bekannten Stanzautomaten ist es im allgemeinen nur mit einer aufwendigen Mechanik möglich, die erforderliche Genauigkeit einzuhalten. Dabei besteht die Gefahr, daß es zu Deformationen der Plattenkanten kommen kann, da bei einer Dreipunktkontaktanlage stets die gleichen Anlegepunkte angefahren werden müssen, beispielsweise in der Weise, daß die beiden Längskanten und eine Schmalkante durch mechanisches Verstellen in einem Arbeitsvorgang grob und fein bis zum Anliegen an den drei Anlegepunkten ausgerichtet werden. Es treten dabei mechanische Kräfte auf, die zu Deformationen der Plattenkanten führen können, woraus sich an den Anlegepunkten unterschiedliche Positionen der Druckplatte ergeben können. Wenn dieser Fall eintritt, so stimmt der Satzspiegel der Druckplatte nicht mit den Registerlochungen überein. Es liegt auf der Hand, daß bei einem Vierfarbendruck Fehler auftreten, wenn der Satzspiegel nur einer einzigen Druckplatte mit den Registerlochungen nicht übereinstimmt.

Die Deformationen treten vor allem deswegen auf, weil die Dreipunktkontaktanlage herkömmlicher Plattenstanzen die Druckplatte möglichst schnell und mit entsprechender Kraft in einem Arbeitsgang so ausrichtet, daß die Druckplatte mit den Anlegepunkten in Kontakt gelangt.

Aufgabe der vorliegenden Erfindung ist es, ein Verfahren sowie eine Anordnung zum Positionieren von Druckplatten mit großer Genauigkeit zu schaffen, die ohne mechanische Deformation an den Plattenkanten der Druckplatte und zumindest so schnell wie herkömmliche Positionierverfahren und Plattenstanzen arbeiten.

Diese Aufgabe wird verfahrensgemäß dadurch gelöst, daß zumindest zwei Meßmarken auf die Druckform aufbelichtet werden, von denen die eine Meßmarke aus einer kreisrunden Schwarzfläche mit einer kreisrunden Weißfläche im Zentrum und die andere Meßmarke aus zwei parallel zu einer Kante der Druckform verlaufenden Linien mit einer Weißfläche dazwischen besteht, daß je ein Meßlichtstrahl die beiden entwickelten Meßmarken ausleuchtet, daß das von den Meßmarken reflektierte Licht vermessen und die Druckform entsprechend der Intensität des reflektierten Lichtes bis zum Auftreten einer maximalen Intensität des reflektierten Lichtes positioniert wird.

In Ausführung der Erfindung wird die Breite der Weißfläche zwischen den zwei Linien im Bereich 0,05 bis 0,4 mm gewählt.

Als Meßlichtstrahl wird bevorzugt ein Laserstrahl mit Gaußscher Intensitätsverteilung verwendet. Dabei wird der Durchmesser bzw. die Breite der Weißfläche jeder Meßmarke gleich einer Strahlbreite des Meßlichtstrahls gewählt, die zwischen dem Pegel der Halbwertsbreite und dem Pegel der $1/e^2$-Intensität des Meßlichtstrahls liegt.

Die Anordnung zum Durchführen des Verfahrens, mit einem lagefesten Laser, einem Strahlteiler im Strahlengang des Lasers zum Aufteilen des Strahls in zwei zueinander parallelen Laserteilstrahlen, von denen jeder eine Anzahl von ringförmig angeordneten Detektoren durchstrahlt, deren lichtempfindliche Schichten der Druckform zugewandt sind und die von den Meßmarken reflektierten Laserteilstrahlen empfangen, zeichnet sich dadurch aus, daß die elektrischen Ausgänge der zu zwei ringförmigen Elementen zusammengefaßten Detektoren mit je einem Strom-/Spannungswandler verbunden sind, die über Steuerschaltungen mit Linearverstellelementen bzw. einem Rotationsverstellelement in Verbindung sind. In Weiterbildung der Anordnung positionieren die Linearverstellelemente die Druckform in x- und y-Richtung der Auflageebene der Druckform und das Rotationsverstellelement die Druckform um einen Drehwinkel in der Auflageebene. In der Offenlegungsschrift DE-A-3 116 634 ist eine Justiervorrichtung zum automatischen Positionieren eines ebenen Gegenstandes mit zwei Bezugspunkten in seiner Ebene gegenüber einer Soll-Position beschrieben. Zu diesem Zweck werden zwei parallele Lichtstrahlenbündel mit den beiden Bezugspunkten des Gegenstandes zur Deckung gebracht, indem die Reflexion oder die Beugung der Lichtstrahlenbündel am Gegenstand durch Detektoren gemessen und hieraus ein Steuersignal abgeleitet wird, um damit die Bewegung des Gegenstandes in die Soll-Position zu steuern. Zum automatischen Positionieren einer Halbleitermaske sind jeweils mehrere Detektoren kreisförmig um zwei zueinander parallele Laserteilstrahlen angeordnet. Mit den Ausgangssignalen der Detektoren wird die Bewegung der Halbleitermaske aufgrund der durch die Bezugsmarkierungen auf der Halbleitermaske und dem Substrat erzeugten Beugungsmuster gesteuert.

Die Erfindung wird im folgenden anhand der Zeichnungen näher erläutert. Es zeigen:

Fig. 1 eine Draufsicht auf eine Druckform in Gestalt einer Druckplatte, die Meßmarken und Registerlochungen aufweist,

Fig. 2 eine Draufsicht auf eine mit Toner entwickelte, kreisrunde Meßmarke, die sich auf der Druckplatte nach Fig. 1 befindet sowie den Zusammenhang zwischen einer Weißfläche der Meßmarke und der Intensitätsverteilung eines Meßlichtstrahls, der die Meßmarke ausleuchtet,

Fig. 3 eine prinzipielle Anordnung zum Positionieren der Druckplatte, und

Fig. 4 eine schematische Darstellung von Einzelheiten der Anordnung nach Fig. 3.

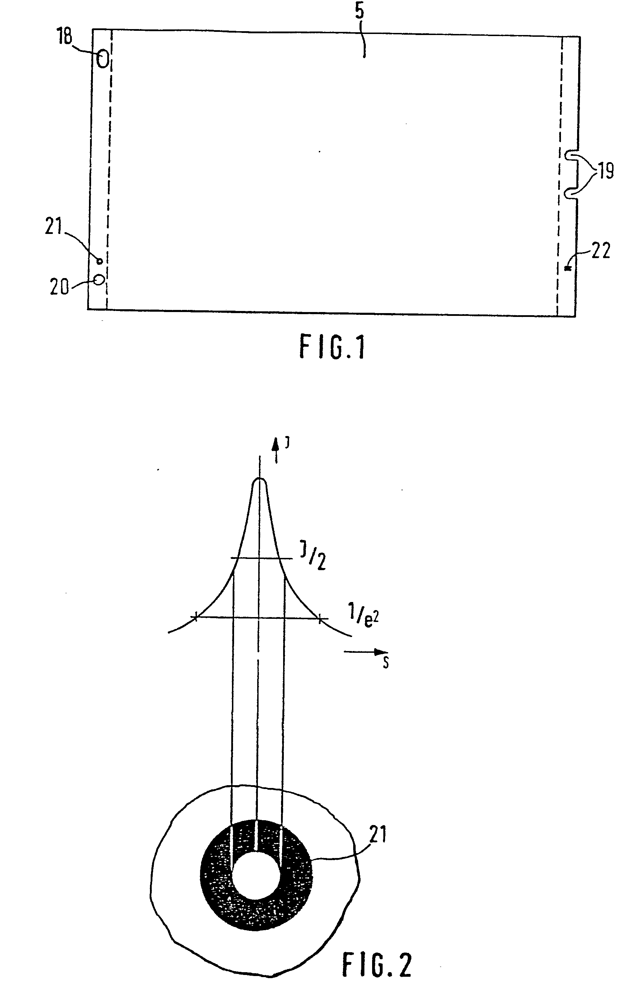

Eine in Fig. 1 gezeigte Druckplatte 5 weist entlang ihrer Schmalseiten Registerlochungen 18, 20 und 19 auf, die unterschiedliche Formen besitzen. Eine Meßmarke 21 nahe der einen Registerlochung 20 besteht aus einer kreisrunden Schwarzfläche von 1 bis 3 mm Durchmesser, die im Zentrum eine Weißfläche von 0,05 bis 0,4 mm Durchmesser aufweist. Eine dieser Meßmarke 21 gegenüberliegende Meßmarke 22 besteht aus zwei parallel zur Längskante der Druckplatte 5 verlaufende Linien von 2 bis 5 mm Länge, die bei einer Breite von 1 bis 3 mm eine Weißfläche von 0,05 bis 0,4 mm Breite einschließen. Die Breite dieser Weißfläche bzw. der Abstand zwischen den beiden Linien dieser Meßmarke 22 ist gleich dem Durchmesser der Weißfläche der anderen Meßmarke 21. Obwohl dies nicht dargestellt ist, können auch mehr als zwei Meßmarken auf der Druckplatte 5 angeordnet sein. Den Meßmarken 21 und 22 befinden sich gegenüberliegend die beiden Abkantflächen der Druckplatte 5, in denen auch die Registerlochungen 18, 20 bzw. 19 liegen. Bei der registerhaltigen Plattenabkantung, die für das Aufspannen der Druckplatte auf die Rotationsmaschine im allgemeinen notwendig ist, werden in der Abkanteinheit eines Abkantautomaten die Abkantflächen entlang der in Fig. 1 gestrichelten parallelen Linien zu den Schmalseiten der Druckplatte 5 abgekantet, nachdem zuvor die Druckplatte mit Registrierstiften, die die Registerlochungen 18, 20 bzw. 19 durchsetzen, mit großer Genauigkeit positioniert wurde.

Die Meßmarken 21 und 22 werden in vorgegebener Lage zum Satzspiegel der Vorlage, die auf die aufgeladene Druckplatte 5 projiziert wird, aufbelichtet, und anschließend wird die Druckplatte 5 mit Toner entwickelt. Anschließend werden die entwickelten Meßmarken 21 und 22 fixiert und entschichtet und sind dem Satzspiegel lagegenau zugeordnet. Die Vorlagen für die Meßmarken 21, 22 befinden sich beispielsweise auf der Glasplatte einer Vorlagenhalterung, in welche die auf die Druckplatte 5 aufzubelichtende Vorlage eingelegt wird. Eine andere Möglichkeit des Aufbelichtens der Meßmarken besteht darin, diese auf eine Meßfolie oder eine Montagefolie aufzudrucken, die vor dem Belichten auf die Vorlage in der Vorlagenhalterung aufgelegt wird. Die entwickelten Meßmarken 21, 22 werden, wie nachstehend noch näher beschrieben wird, optisch vermessen, um die Druckplatte 5 mit großer Genauigkeit für das Stanzen der Registerlochungen 18, 20 bzw. 19 zu positionieren. Das Ausrichten der Druckplatte 5 erfolgt zunächst durch eine Grobverstellung, an die sich eine Feinverstellung anschließt, die aufgrund der von den Meßmarken empfangenen Meßwerte der reflektierten Meßlichtstrahlen so lange erfolgt, bis die Meßwerte einen Maximalwert erreicht haben.

Bevor auf das Meßverfahren bzw. auf die Positionierung der Druckplatte 5 im einzelnen eingegangen wird, wird anhand von Fig. 2 der Zusammenhang zwischen der kreisrunden Meßmarke 21 und der Intensitätsverteilung des Meßlichtstrahls, der die Meßmarke 21 ausleuchtet, erläutert. Als Meßlichtstrahl, der die Meßmarke 21 ausleuchtet, wird ein Laserstrahl mit Gauß'scher Intensitätsverteilung verwendet. Der Durchmesser d der Weißfläche der Meßmarke 21, 22 ist einerseits größer als die Halbwertsbreite des Meßlichtstrahls und andererseits kleiner als die Breite des Meßlichtstrahls bei einem Pegel, welcher der $1/e^2$-Intensität des Meßlichtstrahls entspricht. In analoger Weise gilt, obgleich dies nicht dargestellt ist, für die Meßmarke 22, daß der Abstand bzw. die Breite der Weißfläche zwischen den beiden zueinander parallelen Linien diese Meßmarke einerseits größer als die Halbwertsbreite des Meßlichtstrahls ist und andererseits kleiner als die Breite des Meßlichtstrahls bei einem Pegel gleich der $1/e^2$-Intensität des Meßlichtstrahls. Zum Positionieren der Druckplatte 5 leuchtet je ein Meßlichtstrahl die beiden entwickelten Meßmarken 21 und 22 aus, und das von den Meßmarken reflektierte Licht wird gemessen und die Druckplatte entsprechend der Intensität des reflektierten Lichtes bis zum Auftreten einer maximalen Intensität des reflektierten Lichtes positioniert. Dabei wird davon Gebrauch gemacht. daß das Reflexionsvermögen der Weißfläche der Meßmarken etwa gleich dem zwanzigfachen Betrag des Reflexionsvermögens der Schwarzflächen, d. h. der mit Toner entwickelten Flächen, der Meßmarken ist. Wird der einzelne Meßlichtstrahl teils von der Schwarzfläche und teils von der Weißfläche reflektiert, so nimmt die Intensität des reflektierten Meßlichtstrahls einen bestimmten Wert an, der mit steigendem Anteil der Weißfläche an der Ausleuchtung der Meßmarke bzw. an der Reflexion des Lichtmeßstrahls größer wird und einen Maximalwert dann erreicht, wenn durch eine zu dem Anstieg der gemessenen Intensität des reflektierten Lichtmeßstrahls korrespondierende Ausrichtung der Druckplatte und damit der Meßmarke, die Weißfläche der Meßmarke in bezug auf den Meßlichtstrahl zentriert ist.

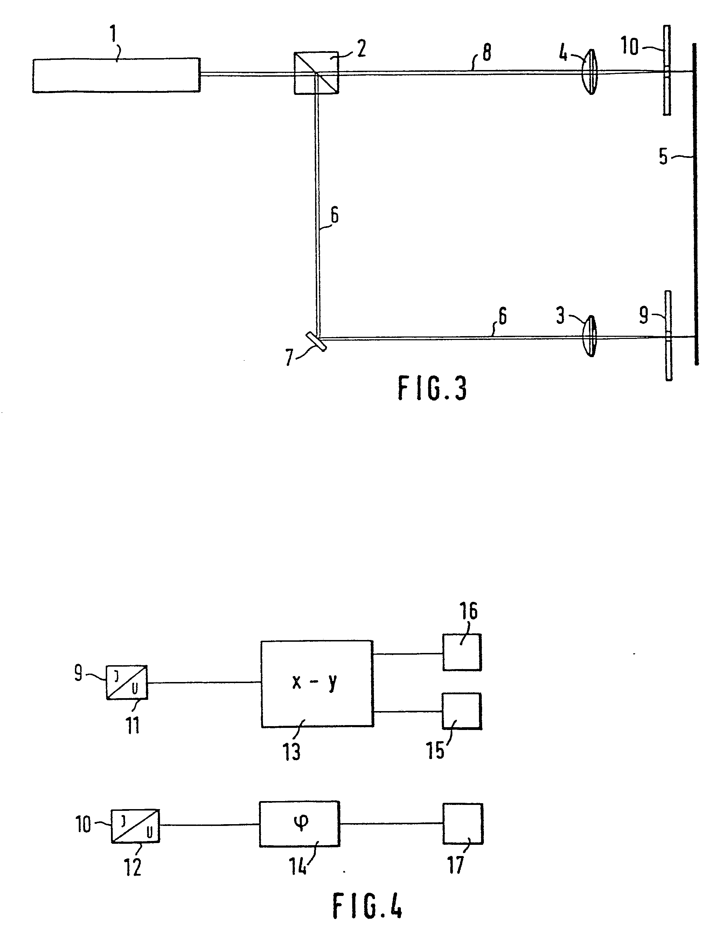

Fig. 3 zeigt schematisch eine prinzipielle Anordnung zum Positionieren der Druckplatte 5, während in Fig. 4 Einzelheiten dieser Anordnung schematisch dargestellt sind. Die Anordnung umfaßt einen lagefesten Laser 1, einen Strahlteiler 2 im Strahlengang des Ausgangsstrahls des Lasers 1, der den Ausgangsstrahl in zwei zunächst senkrecht zueinander verlaufende Laserstrahlen 6 und 8 aufteilt, von denen der Laserstrahl 6 durch einen Umlenkspiegel 7 parallel zu dem anderen Laserstrahl 8 gelenkt wird. In den Strahlengängen der Laserstrahlen 6 und 8 befinden sich Linsen 3 und 4, die vor ringförmigen lichtempfindlichen Elementen 9 und 10 angeordnet sind. Diese ringförmigen Elemente 9 und 10 werden in der Mitte von dem jeweiligen Laserstrahl 6 bzw. 8 durchstrahlt, und ihre lichtempfindlichen Schichten sind der Druckplatte 5 zugewandt. Die Laserstrahlen 6 und 8 treffen auf die Meßmarken 21 und 22 auf und werden von diesen auf die lichtempfindliche Schicht des jeweiligen zugehörigen ringförmigen Elements 9 bzw. 10 reflektiert. Die ringförmigen Elemente 9 und 10 können Fotodetektoren sein, die aus einer Anzahl von Fotozellen bestehen, die ringförmig um den Laserstrahl angeordnet sind. Bei den Fotozellen kann es sich beispielsweise um großflächige Siliciumzellen handeln. Anstelle eines einzigen Lasers, dessen Strahl mittels eines Strahlteilers in zwei Laserstrahlen aufgeteilt wird, können auch zwei Laser vorgesehen werden, von denen jeder direkt einen Meßlichtstrahl auf die Druckplatte 5 richtet. Sind mehr als zwei Meßmarken auf der Druckplatte 5 vorhanden, so müssen entsprechend viele Laserstrahlen vorgesehen werden. Die Intensitätsverteilung in jedem einzelnen Laserstrahl ist gaußförmig. Wie schon zuvor erwähnt wurde, ist der Durchmesser des einzelnen auftretenden Meßlichtstrahls größer als der Durchmesser bzw. die Breite der Weißfläche der Meßmarken. Bevorzugt wird dabei eine Strahlbreite, bei der der Durchmesser bzw. die Breite der Weißfläche der einzelnen Meßmarke den Meßlichtstrahl zwischen dem $1/e^2$ - und dem Halbwerts-Intensitätspegel schneidet. Die Meßlichtstrahlen treffen senkrecht auf die Druckplatte 5 auf und sind in einer lagefesten Beziehung zu dem Stanzwerkzeug in der Abkanteinheit eines Abkantautomaten angeordnet.

Wie aus Fig. 4 ersichtlich ist, sind die elektrischen Ausgänge der ringförmigen Elemente 9 und 10 mit Strom-/Spannungswandlern 11 und 12 verbunden. In den Spannungswandlern wird der von dem reflektierten Meßlichtstrahl erzeugte Fotostrom in dem jeweiligen ringförmigen lichtempfindlichen Element in eine Gleichspannung umgewandelt, die den Steuerschaltungen 13 und 14 zugeleitet wird. Die Steuerschaltung 13 ist mit Linearverstellelementen 15 und 16 zum Positionieren der Druckplatte 5 in x- und y-Richtung verbunden. Die Steuerschaltung 14 steht in Verbindung mit einem Rotationsverstellelement 17 zum Positionieren der Druckplatte 5 um einen Drehwinkel φ in der x-y-Ebene. Bei den Linearverstellelementen und dem Rotationsverstellelement handelt es sich um bekannte Bauteile, wobei eine Bewegungskette im allgemeinen aus Motor, Drehgeber, Reduktionsgetriebe und einem Spindel-Mutter-Getriebe besteht.

Die Grobpositionierung einer Druckplatte erfolgt entlang einer Schmalseite und einer Längsseite auf etwa 0,2 bis 0,3 mm genau. Dabei werden die Meßmarken 21 und 22 durch den jeweiligen Laserstrahl 6 bzw. 8 teilweise ausgeleuchtet. Für die Feinpositionierung wird beispielsweise zunächst die Meßmarke 21 mittels der Linearverstellelemente 15 und 16 mit großer Genauigkeit ausgerichtet, wobei diese Meßmarke den Drehpunkt für die nachfolgende Feinverstellung mit Hilfe des Rotationsverstellelements 17 bildet. Dazu wird das Rotationsverstellelement 17 so lange betätigt, bis der von der Meßmarke 22 reflektierte Meßlichtstrahl ein Maximum erreicht hat.

Die Weißflächen der Meßmarken 21 und 22 werden im allgemeinen von dem anodisierten Aluminium der Druckplatte 5 gebildet, das eine gegenüber den tonerentwickelten Stellen der Druckplatte 5 wesentlich erhöhte Reflexion besitzt. Durch die rauhe Oberfläche der Druckplatte 5 werden die Laserstrahlen unter verschiedenen Winkeln reflektiert, so daß sichergestellt ist, daß der reflektierte Laserstrahl auf das zugehörige lichtempfindliche Element 9 bzw. 10 auftrifft und nicht exakt in seinen Strahlengang zurückreflektiert wird.

Die Meßmarken können auf die Druckplatte 5 auch mit Hilfe einer geeigneten Optik eingespiegelt werden, falls die Montagefolie keinen Platz mehr zum Auftragen der Meßmarken aufweist. Eine weitere Möglichkeit des Anbringens der Meßmarken besteht darin, daß die Vorlagen für die auf die Druckplatte zu projizierenden Meßmarken auf den Stirnflächen der Registerstifte für die Druckvorlage in der Vorlagenhalterung angeordnet sind.

## Patentansprüche

1. Verfahren zum Positionieren von Druckformen anhand von Ausrichtmarken, in dem während der Belichtung der Druckform durch eine Vorlage gleichzeitig Meßmarken in vorgegebener Lage zum Satzspiegel der Vorlage aufbelichtet werden, die anschließend mit der Druckform durch Toner entwickelt werden, dadurch gekennzeichnet, daß zumindest zwei Meßmarken auf die Druckform aufbelichtet werden, von denen die eine Meßmarke aus einer kreisrunden Schwarzfläche mit einer kreisrunden Weißfläche im Zentrum und die andere Meßmarke aus zwei parallel zu einer Kante der Druckform verlaufenden Linien mit einer Weißfläche dazwischen besteht, daß je ein Meßlichtstrahl die beiden entwickelten Meßmarken ausleuchtet, daß das von den Meßmarken reflektierte Licht vermessen und die Druckform entsprechend der Intensität des reflektierten Lichtes bis zum Auftreten einer maximalen Intensität des reflektierten Lichtes positioniert wird.

2. Verfahren nach Anspruch 1, dadurch gekennzeichnet, daß die Breite der Weißfläche zwischen den zwei Linien im Bereich 0,05 bis 0,4 mm gewählt wird.

3. Verfahren nach Anspruch 2, dadurch gekennzeichnet, daß als Meßlichtstrahl ein Laserstrahl mit Gauß'scher Intensitätsverteilung verwendet wird.

4. Verfahren nach Anspruch 3, dadurch gekennzeichnet, daß der Durchmesser bzw. die Breite der Weißfläche jeder Meßmarke gleich einer Strahlbreite des Meßlichtstrahls gewählt wird, die zwischen dem Pegel der Halbwertsbreite und dem Pegel der $1/e^2$-Intensität des Meßlichtstrahls liegt.

5. Anordnung zum Durchführen des Verfahrens nach den Ansprüchen 1 bis 4, mit einem lagefesten Laser, einem Strahlteiler im Strahlengang des Lasers zum Aufteilen des Strahls in zwei zueinander parallelen Laserteilstrahlen, von denen jeder eine Anzahl von ringförmig angeordneten Detektoren durchstrahlt, deren lichtempfindliche Schichten der Druckform zugewandt sind und die von den Meßmarken reflektierten Laserteilstrahlen empfangen, dadurch gekennzeichnet, daß die elektrischen Ausgänge der zu zwei ringförmigen Elementen (9, 10) zusammengefaßten Detektoren mit je einem Strom-/Spannungswandler (11 bzw. 12) verbunden sind, die über Steuerschaltungen (13, 14) mit Linearverstellelementen (15, 16) bzw. einem Rotationsverstellelement (17) in Verbindung sind.

6. Anordnung nach Anspruch 5, dadurch gekennzeichnet, daß die Linearverstellelemente (15, 16) die Druckform (5) in x- und y-Richtung der Auflageebene der Druckform und das Rotationsverstellelement (17) die Druckform um einen Drehwinkel ($\varphi$) in der Auflageebene positionieren.

## Claims

1. A process for the positioning of printing forms by means of guide marks, in which, during the exposure of the printing form through an original, at the same time measurement marks in a predetermined position relative to the printing area of the original are exposed, which are subsequently developed with the printing form by means of toner, wherein at least two measurement marks are exposed on the printing form, of which one measurement mark consists of a circular black surface with a circular white surface in the center and the other measurement mark consists of two lines extending parallel to one edge of the printing form with a white surface between the lines, wherein a respective measurement light beam illuminates the two developed measurement marks, and wherein the light refelected from the measurement marks is measured and the printing form is positioned, in dependence upon the intensity of the reflected light, until a maximum intensity of the reflected light is reached.

2. The process as claimed in claim 1, wherein the width of the white surface between the two lines is selected to be in the range from 0.05 to 0.4 mm.

3. The process as claimed in claim 2, wherein a laser beam with a Gaussian intensity distribution is employed as a measurement light beam.

4. The process as claimed in claim 3, wherein the diameter or the width of the white surface of each measurement mark is selected to be equal to a beam width of the measurement light beam which is between the level of the half width and the level of the $1/e^2$ intensity of the measurement light beam.

5. An arrangement for carrying out the process as claimed in claims 1 to 4, comprising a laser of fixed position, a beam splitter in the beam path of the laser for splitting the beam into two mutual parallel partial laser beams, each of which irradiates a number of annularly arranged detectors, the light-sensitive layers of which face the printing form and receive the partial laser beams reflected by the measurement marks, wherein the electrical outputs of the detectors combined to form two annular elements (9, 10) are connected with a current/voltage converter each (11 or 12) which are connected, via control circuits (13, 14), with linear displacement elements (15, 16) or with a rotary displacement element (17), respectively.

6. The arrangement as claimed in claim 5, wherein the linear displacement elements (15, 16) position the printing form (5) in the x and y direction of the supporting plane of the printing form and the rotary displacement element (17) positions the printing form with reference to an angle of rotation (φ) in the supporting plane.

**Revendications**

1. Procédé pour positionner des formes d'impression sur la base de marques d'alignement, selon lequel, pendant l'exposition de la forme d'impression avec un original, on éclaire simultanément des marques de mesure, qui sont situées dans une position prédéterminée par rapport à la surface d'impression de l'original et qu'on développe ultérieurement avec la forme d'impression au moyen d'un toner, caractérisé en ce qu'on éclaire au moins deux marques de mesure situées sur la forme d'impression, dont l'une est constituée par une surface circulaire noire comportant, en son centre, une surface circulaire blanche, et dont l'autre est constituée de deux traits, qui sont parallèles à un bord de la forme d'impression et entre lesquels est disposée une surface blanche, qu'un faisceau respectif de la lumière de mesure éclaire les deux marques de mesure développées, qu'on mesure la lumière réfléchie par les marques de mesure et qu'on positionne la forme d'impression en fonction de l'intensité de la lumière réfléchie, jusqu'à l'obtention d'une intensité maximale de la lumière réfléchie.

2. Procédé selon la revendication 1, caractérisé en ce qu'on choisit pour la surface blanche présente entre les deux traits, une largeur allant de 0,05 à 0,4 mm.

3. Procédé selon la revendication 2, caractérisé en ce qu'on utilise comme faisceau de lumière de mesure, un faisceau laser possédant une distribution d'intensité gaussienne.

4. Procédé selon la revendication 3, caractérisé en ce qu'on choisit le diamètre ou la largeur de la surface blanche de chaque marque de mesure égale à une largeur du faisceau de lumière de mesure, qui est comprise entre le niveau correspondant à la demi-largeur et le niveau correspondant à l'intensité $1/e^2$ du faisceau de lumière de mesure.

5. Dispositif pour la mise en oeuvre du procédé selon les revendications 1 à 4, comportant un laser fixe en position, un diviseur de faisceau situé dans le trajet du rayonnement du laser et servant à subdiviser le faisceau en deux faisceaux laser partiels parallèles entre eux, dont chacun traverse un certain nombre de détecteurs disposés en anneau, dont les couches photosensibles sont dirigées vers la forme d'impression et reçoivent les faisceaux laser partiels réfléchis par les marques de mesure, caractérisé en ce que les sorties électriques des détecteurs réunis pour former deux éléments annulaires (9, 10) sont reliées à des transformateurs respectifs d'intensité/tension (11 ou 12), qui sont reliés, par l'intermédiaire de circuits de commande (13, 14), à des éléments (15, 16) de commande de déplacement linéaire ou à un élément (17) de commande de déplacement en rotation.

6. Dispositif selon la revendication 5, caractérisé en ce que les éléments (15, 16) de commande de déplacement linéaire positionnent la forme d'impression (5) dans les directions x et y du plan d'appui de la forme d'impression et que l'élément (17) de commande de déplacement en rotation positionne la forme d'impression sur un angle de rotation (φ) dans le plan d'appui.

FIG.1

FIG.2

FIG.3

FIG.4